# EUROPÄISCHE PATENTSCHRIFT

(11) **EP 3 970 195 B1**
(45) Veröffentlichungstag und Bekanntmachung des Hinweises auf die Patenterteilung: **18.02.2026**
(21) Anmeldenummer: 20728420.9
(22) Anmeldetag: 14.05.2020
(51) Int. Cl.: H01J 37/317, H10D 30/01, H10D 30/66, H01L 21/04, H01L 21/266, H10D 62/13, H10D 62/10, H10D 62/60, H10D 62/832

(54) **VERFAHREN ZUR HERSTELLUNG VON HALBLEITERBAUELEMENTEN**
METHOD FOR PRODUCING SEMICONDUCTOR COMPONENTS
PROCÉDÉ DE FABRICATION DE COMPOSANTS SEMI-CONDUCTEURS

(30) Priorität: 16.05.2019 DE 102019112985
(43) Veröffentlichungstag der Anmeldung: 23.03.2022
(73) Patentinhaber: mi2-factory GmbH, 07745 Jena (DE)
(72) Erfinder: CSATO, Constantin, 95236 Stammbach (DE); KRIPPENDORF, Florian, 07743 Jena (DE)
(74) Vertreter: Wächter, Jochen
(86) Internationale Anmeldenummer: PCT/EP2020/063556
(87) Internationale Veröffentlichungsnummer: WO 2020/229639

(56) Entgegenhaltungen:
- DE-A1- 10 239 312
- US-A1- 2007 108 558
- US-A1- 2019 051 488
- ROLAND RUPP ET AL: "Alternative Highly Homogenous Drift Layer Doping for 650 V SiC Devices", MATERIALS SCIENCE FORUM, vol. 858, 24 May 2016 (2016-05-24), pages 531 - 534, XP055718647, DOI: 10.4028/www.scientific.net/MSF.858.531

## Beschreibung

Die Erfindung betrifft ein Verfahren zur Herstellung von Halbleiterbauelementen.

Diskrete hochsperrende Leistungshalbleiterbauelemente mit mehr als 600V nomineller Sperrspannung werden sowohl in Silizium als auch in SiC im Allgemeinen vertikal aufgebaut. Für Dioden, z.B. MPS (merged-pin-Schottky)-Dioden, Schottkydioden oder p-n Dioden heißt dies, dass die Kathode auf der Substratvorderseite und die Anode auf der Substratrückseite angeordnet ist. Eine ähnliche Anordnung gilt im Falle von vertikalen Leistungs-MOS (metal-oxide-semiconductor) Bauelementen. Gate- und Source-Elektrode befinden sich auf der Substratvorderseite, die Drainelektrode auf der Substratrückseite. Das eigentliche Transistorelement bzw. der Kanalbereich kann bei konventionellen Leistungs-MOSFETs parallel zur Oberfläche (D-MOS) oder senkrecht zur Oberfläche angeordnet sein (Trench-MOS). Spezielle Konstruktionen haben sich für SiC-MOSFETs etabliert, z.B. Trenchtransistoren.

Abhängig von der geforderten Sperrfähigkeit (Reverse Blocking Voltage) wird die Breite der Driftzone (=aktive Zone, spannungsaufnehmende Schicht) eingestellt. Beispielsweise wird die Breite der Driftzone für ein 600 V MOSFET Bauelement in Silizium ca. 50 µm groß sein. Bei sogenannten Superjunction Bauelementen kann die Breite der spannungsaufnehmenden Schicht gegenüber "einfachen" vertikalen MOSFETs etwas reduziert sein. Die Besonderheit dieser Art von vertikalen Bauelementen liegt darin, dass die Driftzone durch alternierend angeordnete vertikale p- und n- dotierte Säulen charakterisiert ist. Die zusätzlich eingebrachte p-Dotierung kompensiert im Sperrfall die erhöhte Ladung im n-dotierten Bereich, welcher im eingeschalteten Zustand den Widerstand zwischen Source-Elektrode und DrainElektrode bestimmt. Somit kann bei gleicher Sperrfähigkeit der Einschaltwiderstand bis zu einem Faktor 10 gegenüber konventionellen vertikalen MOS-Transistoren reduziert werden. Das eigentliche Transistorelement, bzw. der Kanalbereich, kann bei Superjunction-MOSFET Architekturen parallel zur Oberfläche (D-MOS) oder senkrecht zur Oberfläche angeordnet sein (Trench-MOS).

Die speziellen Materialeigenschaften von SiC erfordern für vertikale Leistungshalbleiterbauelemente die Bereitstellung von spezifischen Herstellverfahren und die Anwendung spezifischer Architekturen des Kanal- und Transistorbereichs.

Gemäß dem Stand der Technik werden die aktiven Zonen vieler vertikaler Leistungsdioden bzw. alle Leistungstransistoren (MOSFET) in epitaktischen, d.h. einkristallinen, Schichten, ausgebildet. Diese epitaktischen Schichten werden auf kristallinen Trägerwafern aufgebracht. Damit kann die Dotierung in der aktiven Zone auf die jeweilige Sperrspannung abgestimmt werden und der hochdotierte Trägerwafer kann hinsichtlich seiner Dotierung so optimiert werden, dass sein Beitrag zum Einschaltwiderstand minimiert wird.

Insbesondere bei SiC-Substraten ist die oben beschriebene Herstellung der Schichtstruktur aufwändig und teuer, da zum Einen die Trägerwafer, die im Bauelement jedoch keine aktive Funktion übernehmen, sehr teuer sind und zum Anderen die epitaktische Schichtabscheidung enorm kostenintensiv ist.

Die Veröffentlichung von Roland Rupp et al.: "Alternative Highly Homogenous Drift Layer Doping for 650 V SiC Devices", in MATERIALS SCIENCE FORUM, Bd. 858, 24. Mai 2016, Seiten 531-534, XP055718647, DOI: 10.4028/www.scientific.net/MSF.858.531, beschreibt ein Verfahren zur Erzeugung einer dotierten Driftzone eines Halbleiterbauelements mittels Ionenimplantation in eine auf einem Substrat gewachsene Epitaxieschicht unter Verwendung eines Energiefilters, wobei der Energiefilter eine mikrostrukturierte Membran mit einem vordefinierten Strukturprofil zur Einstellung eines durch die Implantation hervorgerufenen Dotierstofftiefenprofils im Substrat ist.

Der vorliegenden Erfindung liegt die Aufgabe zugrunde, ein Verfahren zur Herstellung von Halbleiterbauelementen anzugeben, mit dem leistungsstarke Halbleiterbauelemente hoher Qualität industriell mit reduziertem Aufwand und geringeren Kosten hergestellt werden können.

Das erfindungsgemäße Verfahren zur Herstellung von Halbleiterbauelementen mit vertikaler Struktur weist die in Anspruch 1 definierten Schritte auf.

Wenn bei der Herstellung eines Halbleiterbauelements die Driftzone nach obigen Schritten erzeugt wird, fallen deutlich geringere Kosten des Herstellprozesses an.

Besonders bevorzugt ist das oben genannte Verfahren, wenn das Halbleitermaterial des Substrats SiC ist. In diesem Fall weist das Substrat eine Dicke von 4 µm bis 30 µm auf. Hier sind die Einsparungen gegenüber herkömmlichen Herstellverfahren besonders hoch.

Es ist bevorzugt, dass das Halbleitermaterial des Substrats vor dem Erzeugen der Driftzone undotiert oder schwach n-dotiert ist.

Die Dicke des Substrats beträgt vorzugsweise zwischen 4 und 25 µm, mehr bevorzugt zwischen 4 und 20 µm, mehr bevorzugt zwischen 4 und 15 µm, mehr bevorzugt zwischen 6 und 14 µm, mehr bevorzugt zwischen 7 und 13 µm. In diesen Bereichen der Dicke des Substrats ist es möglich, durch Ionenimplantation mit heute industriell verfügbaren Beschleunigern eine vollständige Dotierung der Driftzone in SiC zu erzielen.

Bevorzugt erstreckt sich die Driftzone über 40 bis 100%, bevorzugt 50 bis 98%, mehr bevorzugt 60 bis 95% der Höhe des Substrats. In der Regel liegt der Anteil eher in einem höheren Bereich des angegebenen Spektrums.

In einer bevorzugten Ausgestaltung ist die Driftzone nach der Ionenimplantation n-dotiert.

Es ist bevorzugt, dass das Erzeugen der dotierten Driftzone durch Ionenimplantation von einer Seite des Substrats erfolgt. Alternativ kann, insbesondere bei Dicken von SiC-Substraten von mehr als 10 µm, das Erzeugen der dotierten Driftzone durch Ionenimplantation von zwei Seiten des Substrats erfolgen. Dabei ergänzen sich die beiden Implantationen von den zwei Seiten hin zum endgültigen Dotierprofil.

Es ist besonders bevorzugt, wenn das Erzeugen der dotierten Driftzone mit Ionen aus Stickstoff, Phosphor oder Wasserstoff (letzteres nur für Siliziumkristalle) als Dotierstoff erfolgt. Zusätzlich zur Dotierung der Driftzone mittels Ionenimplantation ist es bevorzugt, wenn eine dotierte Feldstoppschicht an einem Rand des Substrats mittels Ionenimplantation unter Verwendung eines Energiefilters erzeugt wird. Dies vereinfacht den Herstellungsprozess weiter und reduziert die Gesamtkosten.

Es ist in der Regel gewünscht, dass die Feldstoppschicht nach der Ionenimplantation n-dotiert ist, wobei die Dotierung der Feldstoppschicht stärker ist als die Dotierung der Driftzone, vorzugsweise mindestens doppelt so stark wie die Dotierung der Driftzone.

Die Dicke der Feldstoppschicht beträgt vorzugsweise zwischen 0,6 µm und 150 µm, mehr bevorzugt zwischen 0,8 µm und 5 µm.

In einer bevorzugten Ausführungsform erfolgt die Ionenimplantation zum Erzeugen der Feldstoppschicht von der Seite des Substrats, auf der die Feldstoppschicht ausgebildet wird. Dadurch wird der Herstellprozess vereinfacht und es können Ionenstrahlen mit geringerer Energie verwendet werden.

Es ist außerdem bevorzugt, dass zusätzlich zur Dotierung der Driftzone mittels Ionenimplantation auch eine oberflächliche funktionale Zone mit Bereichen unterschiedlicher Dotierung unter Verwendung von Ionenimplantation mit einem Energiefilter erzeugt wird. Dadurch wird die Herstellung des Halbleiterbauelements weiter vereinfacht.

Bevorzugt liegt die oberflächliche funktionale Zone an einem Rand des Substrats, der der Feldstoppschicht gegenüberliegt. Auf diese Weise werden Halbleiterbauelemente mit vertikaler Struktur gebildet. Die Implantation der oberflächlichen funktionalen Zone erfolgt vorzugsweise von der Seite des Substrats, auf der die oberflächliche funktionale Zone ausgebildet wird. Hierdurch wird das Verfahren weiter vereinfacht und es kann mit einem Ionenstrahl geringerer Energie gearbeitet werden.

Die Dicke der oberflächlichen funktionalen Zone beträgt vorzugsweise zwischen 0,5 µm und 6 µm, mehr bevorzugt zwischen 0,8 µm und 5 µm.

Zur Bildung von Superjunction-Bauelementen ist es bevorzugt, wenn zusätzlich p-dotierte Säulen im Bereich der Driftzone mittels Ionenimplantation unter Verwendung eines Energiefilters erzeugt werden. Die p-dotierten Säulen dienen zur Ladungskompensation der n-dotierten Bereiche der Driftzone.

Für die Ausbildung der oberflächlichen funktionalen Zone und/oder der p-dotierten Säulen wird das Substrat vorzugsweise bereichsweise maskiert.

Das Bereitstellen des Substrats erfolgt durch Aufspalten eines stabförmigen Ausgangskristalls aus dem Halbleitermaterial in dünne Scheiben. Diese dünnen Scheiben bilden dann jeweils das dünne Substrat, das durch Ionenimplantation weiter behandelt wird.

Nicht Bestandteil der beanspruchten Erfindung ist ein Halbleiterbauelement mit einem Substrat aus Halbleitermaterial, das eine Dicke von 4 µm bis 300 µm, bevorzugt 4 µm bis 30 µm, aufweist, wobei das Halbleiterbauelement ein Dotierprofil des Substrats in einem Mittelbereich des Substrats eine Senke oder eine Erhebung aufweist.

Weitere Vorteile und Merkmale der vorliegenden Erfindung ergeben sich aus der nachfolgenden Beschreibung unter Bezugnahme auf die Zeichnungen.
- Fig. 1: ist eine schematische Darstellung der Aufspaltung eines Ausgangskristalls in dünne Substratscheiben, die im Rahmen der vorliegenden Erfindung verwendet wird;
- Fig. 2: zeigt ein Dotierprofil eines Substrats vor der Ionenimplantation der Driftzone;
- Fig. 3: ist eine schematische Ansicht des Wirkprinzips der Ionenimplantation in ein Substrat unter Verwendung eines Energiefilters;
- Fig. 4: ist eine schematische Darstellung der Wirkweise eines Energiefilters, der beim erfindungsgemäßen Verfahren Verwendung finden kann;
- Fig. 5: ist eine schematische Darstellung verschiedener Dotierprofile, die mittels verschieden strukturierter Energiefilter erzeugt werden können;
- Fig. 6: zeigt schematisch den Ablauf der Dotierung der Driftzone sowie ein daraus resultierendes Dotierprofil des Substrats;
- Fig. 7: zeigt schematisch den Ablauf der Dotierung der Driftzone sowie ein daraus resultierendes alternatives Dotierprofil des Substrats;
- Fig. 8a: zeigt schematisch einen alternativen Ablauf der Dotierung der Driftzone sowie ein daraus resultierendes alternatives Dotierprofil des Substrats, wobei die Implantation von zwei Seiten des Substrats erfolgt;
- Fig. 8b: zeigt ein Summendotierprofil des Substrats bei einer Implantation von zwei Seiten ähnlich wie in Fig. 8a;
- Fig. 9: zeigt schematisch einen alternativen Ablauf der Dotierung der Driftzone sowie ein daraus resultierendes alternatives Dotierprofil des Substrats, wobei die Implantation von zwei Seiten des Substrats erfolgt;
- Fig. 10: zeigt schematisch den Ablauf der Dotierung der Driftzone unter Verwendung einer bereichsweisen Maskierung des Substrats sowie ein daraus resultierendes alternatives Dotierprofil des Substrats;
- Fig. 11: zeigt schematisch den Ablauf einer Ionenimplantation von zwei Seiten des Substrats unter Verwendung von maskierten Bereichen;
- Fig. 12: zeigt schematisch den Ablauf der Ionenimplantation zur Bildung einer Feldstoppschicht und ein daraus resultierendes Dotierprofil des Substrats;
- Fig. 13: zeigt einen schematischen Querschnitt durch ein erstes Beispiel eines Halbleiterbauelements, das mit dem erfindungsgemäßen Verfahren hergestellt wurde, einschließlich des zugehörigen Dotierprofils;
- Fig. 14: zeigt einen schematischen Querschnitt durch ein zweites Beispiel eines Halbleiterbauelements, das nach dem erfindungsgemäßen Verfahren hergestellt wurde; und
- Fig. 15: zeigt einen schematischen Querschnitt durch ein drittes Beispiel eines Halbleiterbauelements, das mit dem erfindungsgemäßen Verfahren hergestellt wurde, sowie zwei zugehörige Dotierprofile in zueinander senkrechten Richtungen.

Das erfindungsgemäße Verfahren zur Herstellung von Halbleiterbauelementen beginnt mit der Bereitstellung eines Substrats 12 aus Halbleitermaterial. Das Material des Substrats 12 ist vorzugsweise Siliziumkarbid (SiC). Es kommen aber auch andere Halbleitermaterialien wie Silizium, Galliumarsenid, Cadmiumtellurid, Zinkselenid, Galliumnitrid etc. in Frage. Die Substrate 12 sind vorzugsweise als Wafer ausgebildet. Das Substrat 12 ist anfangs undotiert oder äußerst schwach n-dotiert, z.B. mit einer Dotierkonzentration von < 5·10¹⁸cm⁻³.

Die Substrate 12 besitzen eine Dicke von 4 µm bis 300 µm. In der Regel sind die Substrate 12 gemäß dem erfindungsgemäßen Verfahren allerdings dünner. Meist besitzen die Substrate 12 eine Dicke von zwischen 4 und 30 µm, bevorzugt zwischen 4 und 25 µm, mehr bevorzugt zwischen 4 und 20 µm, mehr bevorzugt zwischen 4 und 15 µm, mehr bevorzugt zwischen 6 und 14 µm, mehr bevorzugt zwischen 7 und 13 µm.

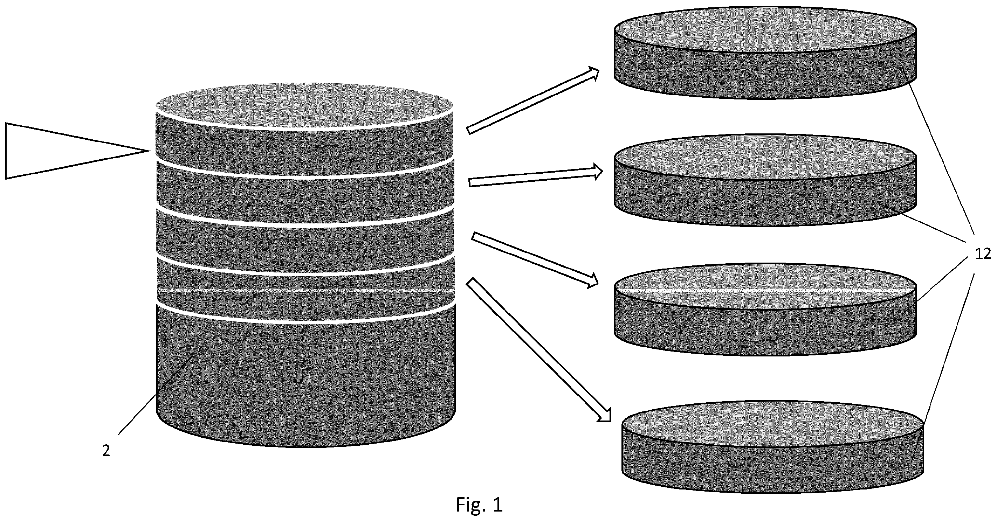

Ein Beispiel für die Gewinnung solcher Substrate 12 ist in Fig. 1 dargestellt. Ein undotierter oder schwach n-dotierter Ausgangskristall 2 (z.B. ein Waferstab) wird in dünne Scheiben aufgespalten, wodurch die Substrate 12 (Dünnwafer) gebildet werden. Die abgespaltenen Substrate 12 können, sofern erforderlich, während des Herstellprozesses temporär, d.h. reversibel, durch Trägerwafer oder ähnliche Strukturen mechanisch gehalten werden, um den Bruch des Substrats 12 zu vermeiden. Eine weitere Alternative ist Dünnschleifen.

Die Dicke der einzelnen Substrate 12 entspricht vorzugsweise einer vorher ermittelten Breite einer Kombination aus aktiver Driftzone zuzüglich einer Feldstoppschicht und einer oberflächlichen funktionalen Zone, wie später näher beschrieben wird. Die Gesamtdicke des Substrats 12 ist somit allein von der Art und vor allem von der Spannungsklasse des herzustellenden Halbleiterbauelements bestimmt. Je höher die Spannungsklasse, umso dicker das Substrat 12. Die obere Grenze von 300 µm ist bedingt durch den sinnvollen Anwendungsbereich der Ionenimplantation (Protonenstrahl in Silizium). In SiC ist die maximale Dicke mit heute industriell verfügbaren Beschleunigern 30 µm. Dies ist auch deshalb eine sinnvolle Obergrenze, weil eine radioaktive Aktivierung des Grundmaterials aufgrund zu hoher Ionenstrahlenergie vermieden werden sollte.

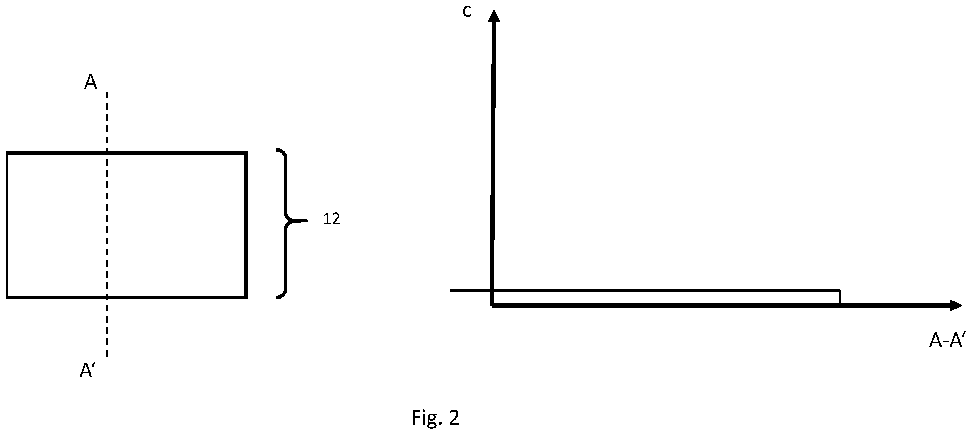

Ein Dotierprofil eines schwach n-dotierten Substrats 12 ist in Fig. 2 dargestellt. Das Dotierprofil ist entlang des Schnitts A-A' gezeigt. c steht für die Dotierkonzentration.

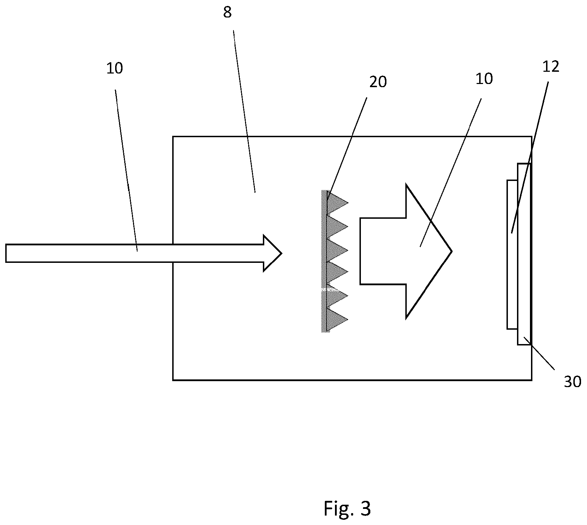

Nach der Bereitstellung der Substrate 12 erfolgt die Erzeugung einer dotierten Driftzone (auch aktive Zone oder spannungsaufnehmende Zone genannt) im Substrat 12 mittels lonenimplantation. Der entsprechende grundsätzliche Aufbau ist in Fig. 3 dargestellt. Der in Fig. 3 gezeigte Aufbau zur Ionenimplantation in ein Substrat 12 zeigt eine Bestrahlungskammer 8, in der üblicherweise ein Hochvakuum vorliegt. In der Bestrahlungskammer 8 ist das zu dotierende Substrat 12 in einer Substrathalterung 30 aufgenommen.

Ein Ionenstrahl 10 wird mittels eines Teilchenbeschleunigers (nicht dargestellt) erzeugt und in die Bestrahlungskammer 8 geleitet. Dort wird die Energie des Ionenstrahls 10 durch einen Energiefilter 20 aufgespreizt und er trifft auf das zu bestrahlende Substrat 12. Alternativ kann der Energiefilter 20 in einer separaten, mit Ventilen verschließbaren Vakuumkammer innerhalb der Bestrahlungskammer 8 oder unmittelbar angrenzend an die Bestrahlungskammer 8 angeordnet sein.

Die Substrathalterung 30 muss nicht stationär sein, sondern kann optional mit einer Einrichtung zum Verschieben des Substrates 12 in x-y (in der Ebene senkrecht zur Blattebene) versehen sein. Als Substrathalterung 30 kommt außerdem auch ein Waferrad in Betracht, auf welchem die zu implantierenden Substrate 12 fixiert werden und das sich während der Implantation dreht. Auch eine Verschiebung der Substrathalterung 30 in Strahlrichtung (z-Richtung) kann möglich sein. Weiterhin kann die Substrathalterung 30 optional mit einer Heizung oder Kühlung versehen sein.

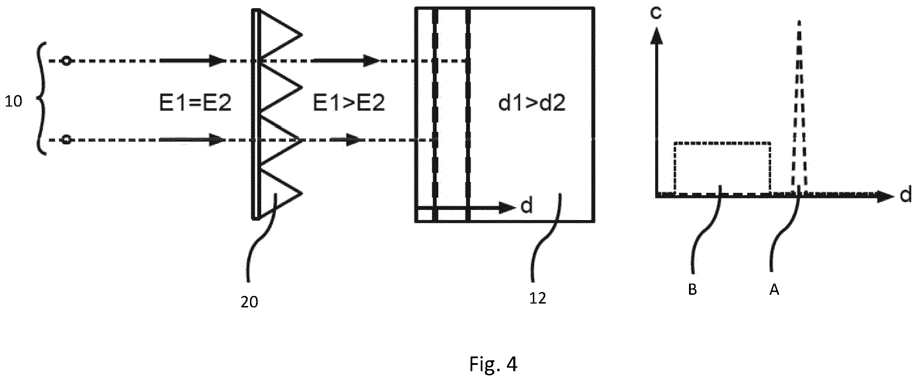

Das Grundprinzip des Energiefilters 20 ist in Fig. 4 dargestellt. Der monoenergetische lonenstrahl 10 wird beim Durchtritt durch den als mikrostrukturierte Membran ausgestalteten Energiefilter 20 abhängig vom Eintrittsort in seiner Energie modifiziert. Die resultierende Energieverteilung der Ionen des Ionenstrahls 10 führt zu einer Modifikation des Tiefenprofils des implantierten Stoffes in der Matrix des Substrats 12. E1 bezeichnet die Energie eines ersten Ions, E2 bezeichnet die Energie eines zweiten Ions, c bezeichnet die Dotierkonzentration und d bezeichnet die Tiefe im Substrat 12. Im Diagramm rechts ist die übliche Gaußverteilung mit Bezugszeichen A gekennzeichnet, die ohne Einsatz eines Energiefilters 20 entsteht. Hingegen ist beispielhaft mit Bezugszeichen B eine Rechteckverteilung skizziert, die bei Einsatz eines Energiefilters 20 erzielt werden kann.

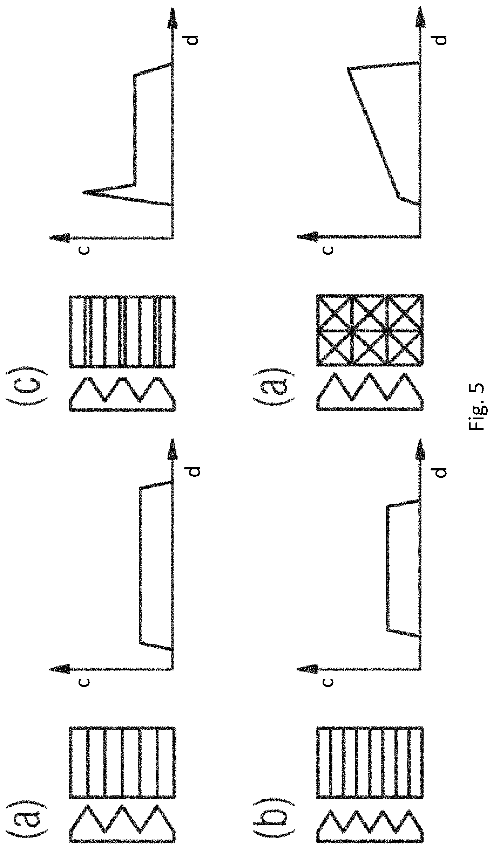

Die in Fig. 5 gezeigten Layouts bzw. dreidimensionalen Strukturen von Energiefiltern 20 zeigen die prinzipiellen Möglichkeiten, mittels Energiefilter 20 eine Vielzahl von Dotierstofftiefenprofilen oder Defekttiefenprofilen zu erzeugen. c bezeichnet wiederum die Dotierkonzentration und d bezeichnet wiederum die Tiefe im Substrat 12. Die Filterstrukturprofile können im Prinzip miteinander kombiniert werden, um neue Filterstrukturprofile und somit neue Dotierstofftiefenprofile oder Defekttiefenprofile zu erhalten.

Derartige Energiefilter 20 sind in der Regel aus Silizium hergestellt. Sie besitzen eine Dicke von zwischen 3 µm und 200 µm, vorzugsweise zwischen 5 µm und 50 µm und besonders bevorzugt zwischen 7 µm und 20 µm. Sie können in einem Filterrahmen (nicht dargestellt) gehalten sein. Der Filterrahmen kann austauschbar in einer Filterhalterung (nicht dargestellt) aufgenommen sein.

Für die bevorzugte Ausbildung einer n-dotierten Driftzone 21 ist die Implantation mit Ionen aus Stickstoff, Phosphor oder Wasserstoff (letzteres nur für Siliziumkristalle) besonders geeignet.

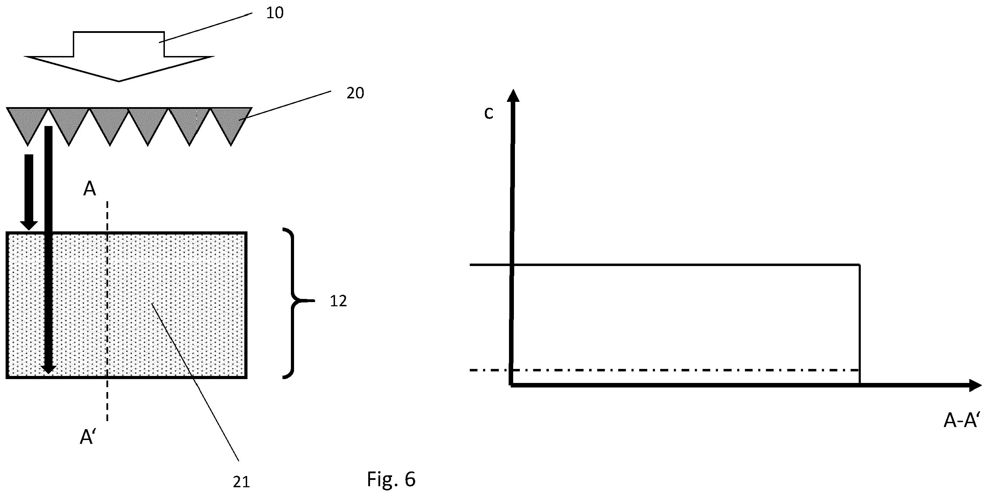

Bei dem in Fig. 6 dargestellten Ausführungsbeispiel des Verfahrensschritts der Dotierung der Driftzone 21 erfolgt die Ionenimplantation in das Substrat 12 von nur einer Seite, hier der Vorderseite des Substrats 12. Der kurze, schwarz gefüllte Pfeil deutet die durch den Energiefilter 20 transmittierten Ionen minimaler Energie an, und der lange, schwarz gefüllte Pfeil deutet die durch den Energiefilter 20 transmittierten Ionen maximaler Energie an. Das resultierende Dotierprofil entlang des Schnitts A-A' ist rechts im Koordinatensystem gezeigt. c steht wiederum für die Dotierkonzentration. Das Dotierprofil ist über das gesamte Substrat 12 hinweg annähernd gleichmäßig. Ebenso kann die Ionenimplantation in das Substrat 12 von der Rückseite des Substrats 12 erfolgen. In diesem Ausführungsbeispiel wird das Substrat 12 ebenso wie in allen anderen Ausführungsbeispielen selbst als Driftzone 21 ausgebildet. Eine Epitaxie-Abscheidung findet nicht statt.

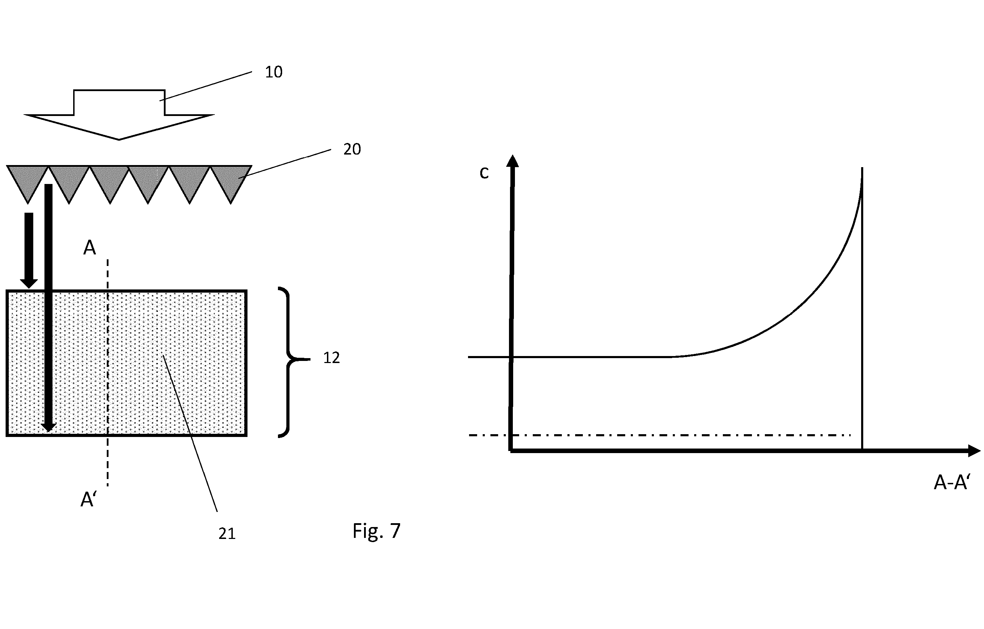

Das in Fig. 7 dargestellte Ausführungsbeispiel des Verfahrensschritts der Dotierung der Driftzone 21 ist ähnlich wie das Ausführungsbeispiel aus Fig. 6. Der einzige Unterschied besteht in der Form des Dotierprofils, das eine zur Rückseite des Substrats 12 ansteigende Form aufweist.

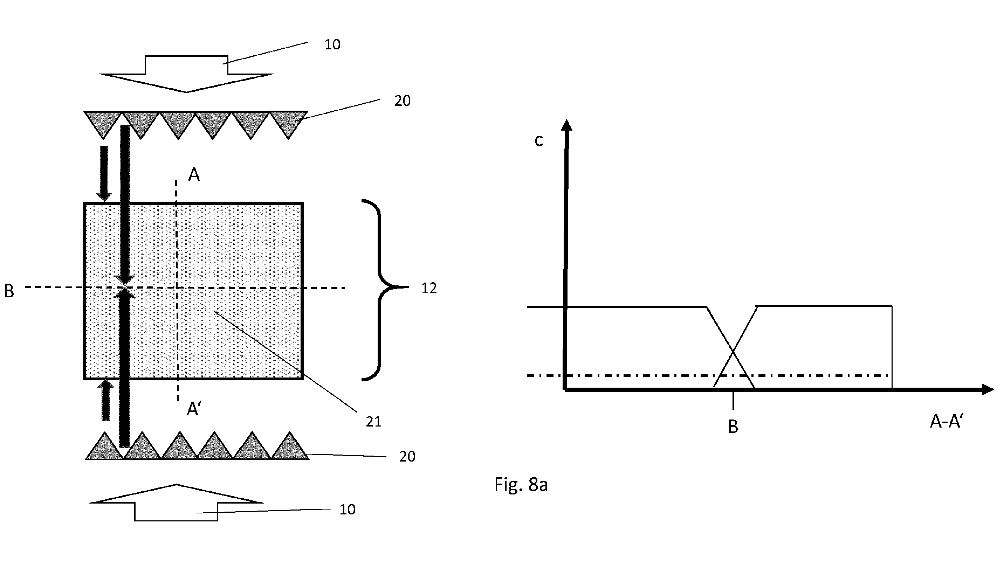

Das in Fig. 8a dargestellte Ausführungsbeispiel des Verfahrensschritts der Dotierung der Driftzone 21 ist ähnlich wie das Ausführungsbeispiel aus Fig. 6, allerdings wird das Substrat 12 von zwei gegenüberliegenden Seiten, hier also Vorderseite und Rückseite des Substrats 12, dotiert. Es wird jeweils von der Vorderseite und der Rückseite des Substrats 12 ein Dotierprofil mittels geeignet ausgebildetem Energiefilter 20 realisiert, wobei jedes Dotierprofil durch ein Konzentrationsplateau P1, P2 und eine Dotierflanke S1, S2 gekennzeichnet ist. Dadurch werden in der Regel überlappende Dotierprofile ausgebildet, und die dotierbare Dicke des Substrats 12 kann auf diese Weise erhöht werden. S1, S2 können neben dem in Fig. 8a gezeigten linearen Anstieg bzw. Abfall auch als beliebige Kurvenform ausgebildet sein. Ebenso können die Plateaus P1 und P2 ansteigend oder fallend bzw. als beliebige Kurvenform ausgestaltet sein.

Beispielsweise ist die Reichweite von Stickstoffimplantationen in SiC mit heute industriell verfügbaren Beschleunigern deutlich begrenzt. Durch zwei kombinierte Implantationen, von denen eine Implantation von der Vorderseite erfolgt und die andere Implantation von der Rückseite erfolgt, kann eine dotierte Substratdicke von bis zu 20 µm, eventuell auch bis zu 30 µm, mit verfügbaren Beschleunigern erreicht werden. Dies erhöht die Spannungsfestigkeit des herzustellenden Halbleiterbauteils.

Die Implantation von zwei Seiten wird meist nacheinander erfolgen. In diesem Fall wird das Substrat 12 zwischen den Implantationen in der Regel um 180° gedreht, sodass mit derselben Strahlvorrichtung gearbeitet werden kann. Es ist aber auch denkbar, die Implantationen von zwei Seiten mit zwei verschiedenen Strahlvorrichtungen auszuführen. Dann ist auch eine gleichzeitige Implantation von beiden Seiten denkbar.

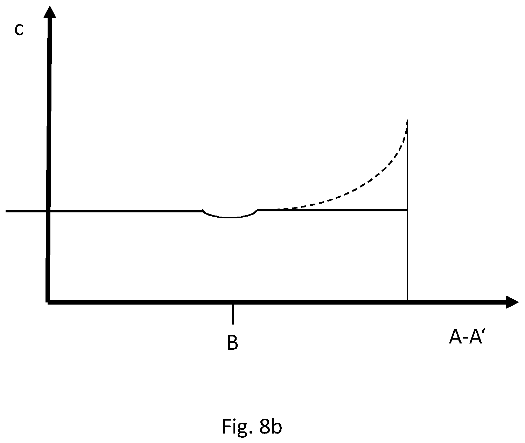

Fig. 8b zeigt ein beispielhaftes Summendotierprofil des Substrats bei einer Implantation ähnlich wie in Fig. 8a. Das Summendotierprofil der Driftzone 21 weist in einem Mittelbereich des Substrats 12 eine Senke auf. Ebenso könnte es an dieser Stelle eine Erhebung aufweisen. Das Dotierprofil der Driftzone 21 ist von einem ersten Randbereich des Substrats 12 (links) zum Mittelbereich hin im Wesentlichen konstant. Ebenso ist das Dotierprofil der Driftzone 21 von einem zweiten Randbereich des Substrats 12 (rechts), der dem ersten Randbereich gegenüberliegt, zum Mittelbereich hin im Wesentlichen konstant.

Es ist auch möglich, dass die Dotierung des Substrats 12 nicht nur zur Herstellung einer Driftzone 21, sondern auch zur Herstellung anderer Bereiche des Halbleiterbauelements 4 verwendet wird. Dann kann es auch sinnvoll sein, wie gestrichelt dargestellt, dass bei einer Implantation von zwei Seiten das Dotierprofil von einem zweiten Randbereich des Substrats 12, der dem ersten Randbereich gegenüberliegt, zum Mittelbereich hin abfällt. Dadurch kann beispielsweise im zweiten Randbereich eine höher dotierte Feldstoppschicht ausgebildet werden.

Der Mittelbereich liegt in allen Ausführungsformen in der Regel innerhalb eines Bereichs von zwischen 20% und 80%, bevorzugt zwischen 30% und 70%, mehr bevorzugt zwischen 40% und 60%, der Dicke des Substrats 12.

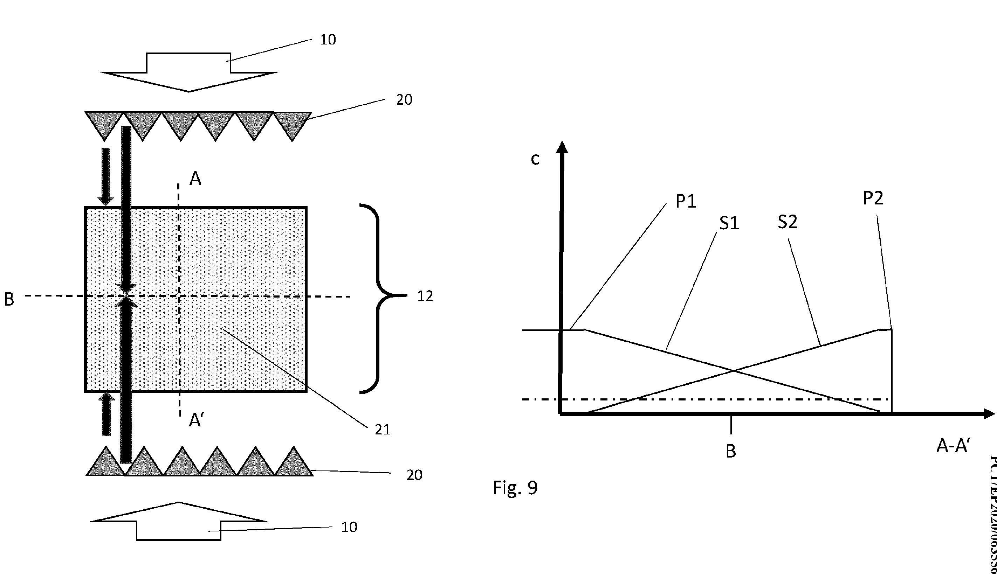

Eine weitere vorteilhafte Ausführungsform ist in Fig. 9 dargestellt. Die Ausführungsform entspricht in wesentlichen Teilen der Ausführungsform nach Fig. 8a und 8b. Es wird wiederum jeweils von der Vorderseite und der Rückseite des Substrats 12 ein Dotierprofil mittels geeignet ausgebildetem Energiefilter 20 realisiert, wobei jedes Dotierprofil durch ein Konzentrationsplateau P1, P2 und eine Dotierflanke S1, S2 gekennzeichnet ist. Der Vorteil dieser Ausgestaltung liegt darin, dass Schwankungen in der Dicke des Substrats 12 sich nur wenig in Schwankungen der resultierenden Summendotierkonzentration auswirken und somit eine Erhebung oder Senke im Mittelbereich der Driftzone 21 möglichst vermieden werden. Je flacher S1 und S2 gestaltet werden, umso kleiner werden resultierende Dotierkonzentrationsschwankungen. S1, S2 können neben dem in Fig. 9 gezeigten linearen Anstieg bzw. Abfall wiederum auch als beliebige Kurvenform ausgebildet sein. Ebenso können die Plateaus P1 und P2 wiederum ansteigend oder fallend bzw. als beliebige Kurvenform ausgestaltet sein.

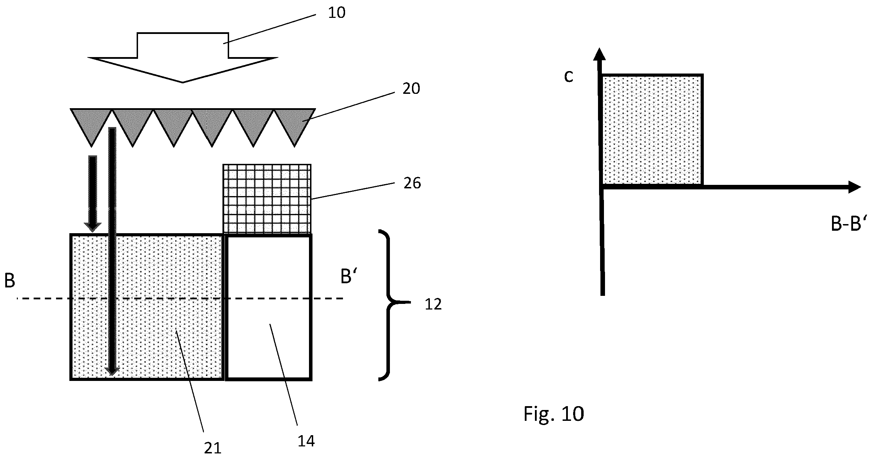

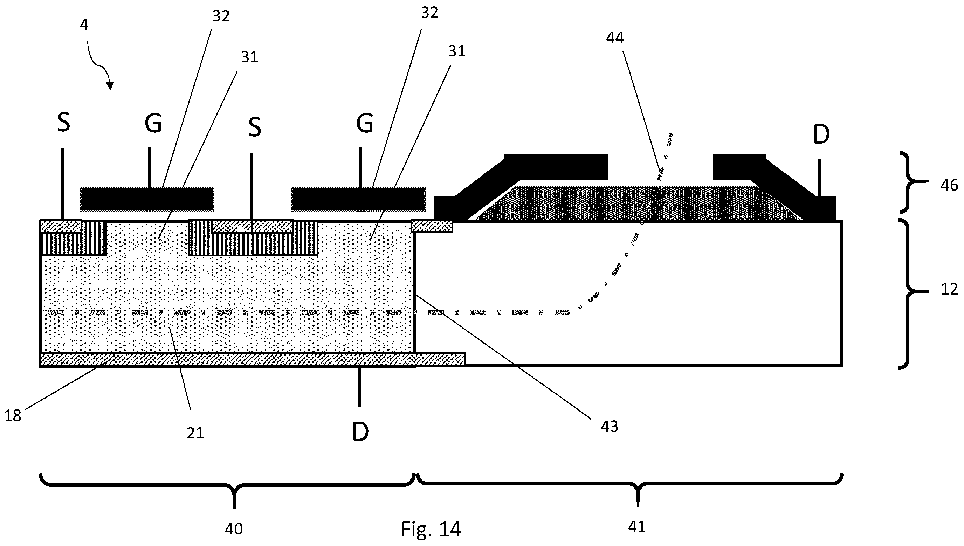

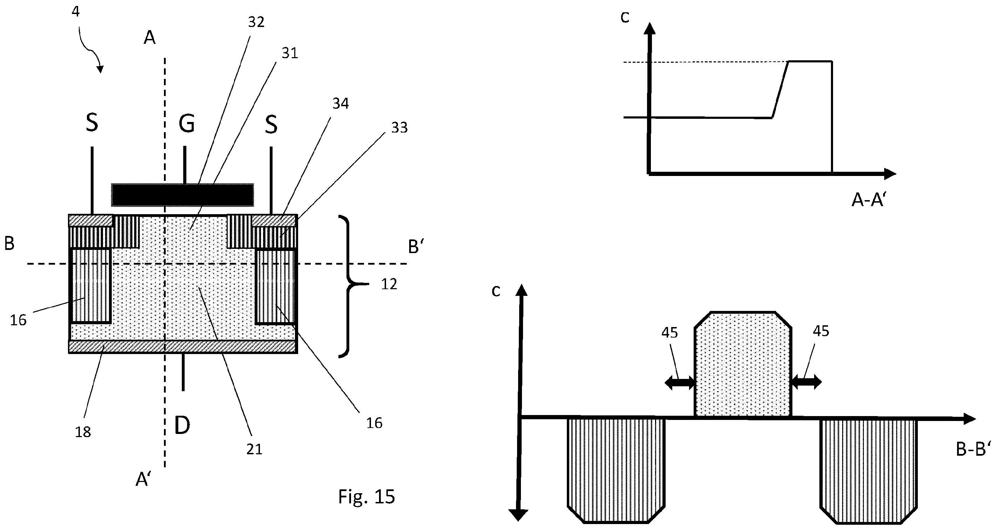

Im Falle der Herstellung bestimmter Bauelemente, wie sie weiter unten unter Bezugnahme auf Fig. 14 und 15 beschrieben sind, muss die energiegefilterte Implantation maskiert werden oder es muss mehrfach eine maskierte energiegefilterte Implantation durchgeführt werden. Wie in Fig. 10 dargestellt, ist auf der Vorderseite des Substrats 12 eine Maskierung 26 angeordnet. Damit wird erreicht, dass der von der Maskierung 26 überdeckte Bereich des Substrats 12 nicht dotiert wird. Die Maskierung 26 muss nicht fest mit dem Substrat 12 verbunden sein, sondern kann auch durch vom Substrat 12 beabstandet angeordnete Siebmasken (nicht dargestellt) realisiert werden.

Wie in Fig. 10 dargestellt, können hierdurch trotz Dotierung der Driftzone 21 beispielsweise undotierte Gebiete 14 im Substrat 12 verbleiben.

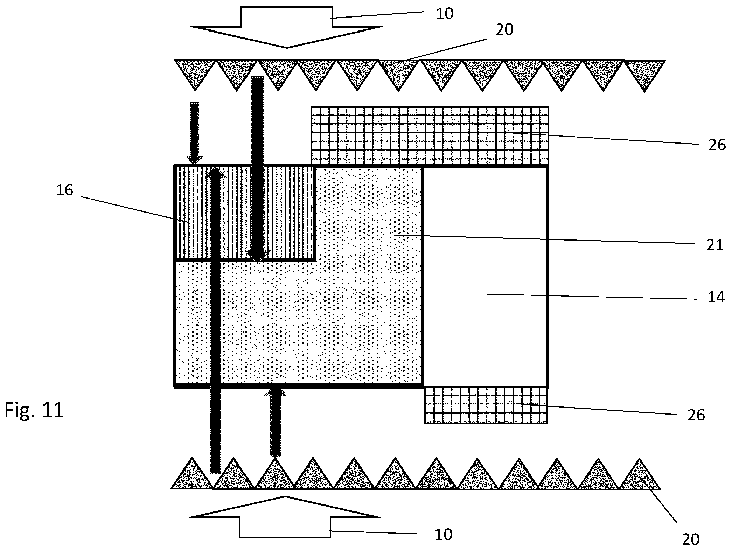

Maskierungen 26 können auch auf gegenüberliegenden Seiten des Substrats 12 ausgebildet sein, dies sogar gleichzeitig. Ein Beispiel hierfür ist in Fig. 11 zu sehen, bei der eine p-dotierte Säule 16 in einer n-dotierten Driftzone 21 ausgebildet wird, wie es für die Herstellung des Halbleiterbauelements 4 nach Fig. 15 notwendig ist. Hier ist der oben dargestellte Ionenstrahl 10 ein Ionenstrahl zur p-Dotierung, beispielsweise mit Aluminiumionen, während der unten dargestellte Ionenstrahl 10 ein Ionenstrahl zur n-Dotierung, beispielsweise mit Stickstoffionen, ist.

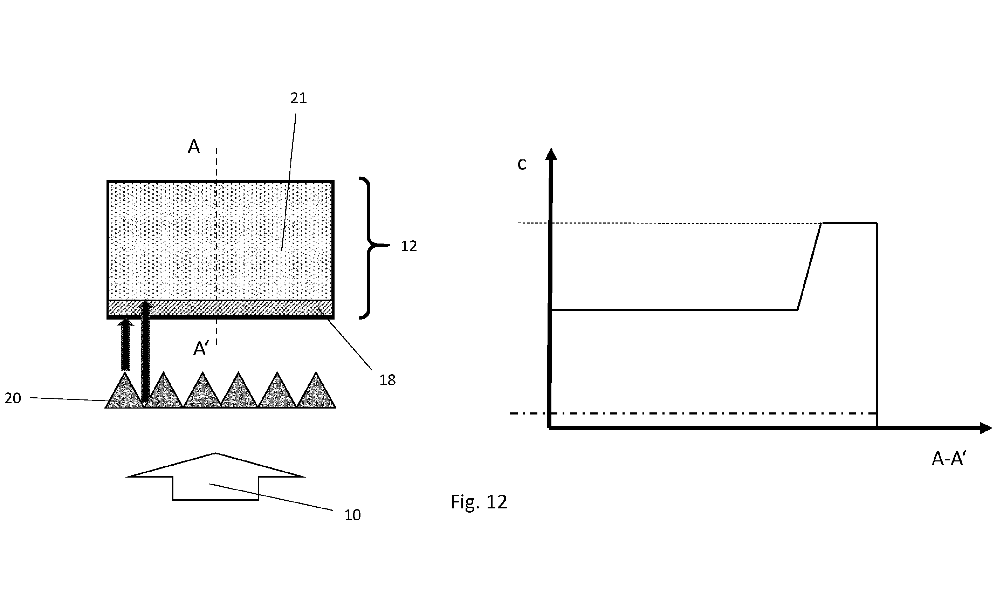

Die in Fig. 12 skizzierte Dotierung einer Feldstoppschicht 18 auf der Rückseite des Substrats 12 wird vor, gleichzeitig oder nach der Ausbildung der Dotierung der Driftzone 21 in das Substrat 12 eingebracht. Die Dotierung der Feldstoppschicht 18 erfolgt bevorzugt von der Rückseite des Substrats 12, kann jedoch auch bei geeigneter Ausgestaltung des Implantationsprozesses und des Energiefilters 20 von der Vorderseite implantiert werden.

Die Feldstoppschicht 18 ist vorzugsweise n-dotiert. Somit sind für die Ausbildung der Feldstoppschicht 18 insbesondere Stickstoffionen oder Phosphorionen geeignet. Die Dotierung der Feldstoppschicht 18 ist stärker als die Dotierung der Driftzone 21. Vorzugsweise ist die Dotierung der Feldstoppschicht 18 mehr als doppelt so stark wie die Dotierung der Driftzone 21. Die Dicke der Feldstoppschicht 18 beträgt zwischen 0,5 µm und 6 µm, bevorzugt zwischen 0,8 µm und 5 µm. Für die Ausbildung der Feldstoppschicht 18 wird kein Epitaxieprozess benötigt.

Ebenso wird auf der Vorderseite des Substrats 12 vor, gleichzeitig oder nach der Ausbildung der Dotierung der Driftzone 21 in das Substrat 12 und ebenso vor, gleichzeitig oder nach der Ausbildung der Dotierung der Feldstoppschicht 18 eine oberflächliche funktionale Zone 24 erzeugt. Dies kann mittels Dotierung verschiedener Bereiche der Vorderseite des Substrats 12 durch Ionenimplantation unter Verwendung eines Energiefilters 20 erfolgen; es sind aber auch andere Techniken denkbar.

Wenn manche oder alle Bereiche der oberflächlichen funktionalen Zone 24 durch Implantation dotiert werden, erfolgt die Dotierung dieser Bereiche der oberflächlichen funktionalen Zone 24 bevorzugt von der Vorderseite des Substrats 12, kann jedoch auch bei geeigneter Ausgestaltung des Implantationsprozesses und des Energiefilters 20 von der Rückseite erfolgen.

Die Dicke der oberflächlichen funktionalen Zone 24 beträgt zwischen 0,5 µm und 6 µm, bevorzugt zwischen 0,8 µm und 5 µm. Die oberflächliche funktionale Zone 24 kann in verschiedenster Weise ausgestaltet sein.

Alle im Rahmen der Erfindung beschriebenen Implantationen müssen in einem Annealprozess ausgeheilt werden, so dass die Dotieratome elektrisch aktiviert werden können.

Auf der Vorderseite des Substrats 12 können schließlich Kanalbereiche, p-n Übergänge, Anschlussmetallisierungen etc. aufgebracht werden. Auf der Rückseite Substrats 12 können eine Drain-Anschlussmetallisierung sowie ggfs. ein n++ dotiertes Anschlussgebiet angeordnet werden.

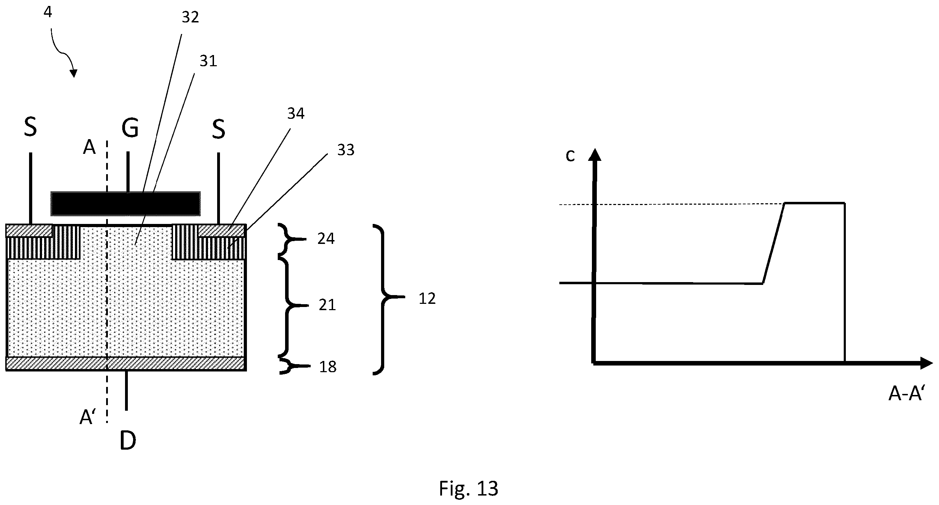

Ein Beispiel eines mit dem erfindungsgemäßen Verfahren hergestellten Halbleiterbauelements 4 mit vertikaler Struktur ist in Fig. 13 dargestellt.

Erfindungsgemäß hergestellt werden kann eine vertikale Halbleiterbauelement-Struktur, insbesondere für Dioden (Schottky, MPS-Diode und pn-Diode) und MOSFETs mit einer oberflächlichen funktionalen Zone 24 (IGBT, MOS-Transistor, Kanalbereich, p-n Übergang, Schottkydiode), einer Driftzone 21 sowie einer Feldstoppschicht 18, jedoch ohne Trägerwafer.

Diese Struktur ist dadurch gekennzeichnet, dass sie hinsichtlich ihrer vertikalen Ausdehnung genau der erforderlichen Breite der Driftzone 21 zuzüglich der Feldstoppschicht 18 und zuzüglich der funktionalen oberflächlichen Zone 24 entspricht. Besonders bemerkenswert ist die Tatsache, dass diese Struktur bei Ausbildung vollständiger vertikaler Hochvoltleistungsbauelemente die minimal denkbare Chipdicke bzw. Dicke des Substrats 12 erreicht.

Im Fall der Fig. 13 ist beispielhaft ein MOSFET dargestellt. S steht für den Sourceanschluss, G für den Gateanschluss und D für den Drainanschluss. Die oberflächliche funktionale Zone 24 besteht aus einem MOS-Kanalbereich 31, einer Gateelektrode 32, einem p-Body 33 und einem Sourceanschlussgebiet 34.

Ein weiteres Beispiel eines mit dem erfindungsgemäßen Verfahren hergestellten Halbleiterbauelements 4 mit vertikaler Struktur ist in Fig. 14 dargestellt. Identische Bezugszeichen bezeichnen identische Elemente wie in Fig. 13.

Reale Hochvoltbauelemente bestehen aus einem aktiven Bereich 40 und einem Randbereich 41. Aufgrund der nicht perfekt isolierenden Sägekante des Substrats 12 wird das Drainpotential am Rand des Substrats 12 immer auch an der Oberfläche anliegen. Die Aufgabe des Randbereiches 41 besteht darin, die Spannung zwischen Source und Drain an der Oberfläche lateral in definierter zuverlässiger Weise abzubauen. Konkret bedeutet dies, dass die Äquipotentiallinien 44 mit definierter Krümmung an die Oberfläche geführt werden müssen. Wichtig ist hierbei, dass die zulässige Feldstärke durch die Krümmung der Äquipotentiallinien 44 nicht überschritten wird. Es ist daher vorteilhaft, die Dotierung im Randbereich zu minimieren.

Bei der Struktur aus Fig. 14 ist Randbereich 41 undotiert bzw. niedriger dotiert Dotierprofil als der aktiven Bereich 40, oder allgemein unterscheidet sich das Dotierprofil im Randbereich 41 vom Dotierprofil im aktiven Bereich 40. Es gibt somit am Übergang zwischen aktivem Bereich 40 und Randbereich 41 einen Übergangsbereich 43, der durch einen Dotierungsgradienten charakterisiert ist. Die Feldstoppschicht 18 kann nur im aktiven Bereich 40 angeordnet sein und am Übergangsbereich 43 enden, sich zusätzlich teilweise in den Randbereich 41 erstrecken oder vollständig über den Randbereich 41 erstrecken. Die in Fig. 14 gezeigte Konstruktion des Randbereichs 41 (Feldplattenrand 46) steht hier nur beispielhaft für weitere denkbare und bekannte Randkonstruktionen, wie etwa p-Ringe.

Ein weiteres Beispiel eines mit dem erfindungsgemäßen Verfahren hergestellten Halbleiterbauelements 4 mit vertikaler Struktur ist in Fig. 15 dargestellt. Identische Bezugszeichen bezeichnen identische Elemente wie in Fig. 13.

Die dargestellte Struktur ist ein Superjunction MOSFET, der identisch zum MOSFET aus Fig. 13 aufgebaut ist, zusätzlich aber noch p-dotierte Säulen 16 oder Gebiete aufweist, die zur Kompensation der n-Dotierung der Driftzone 21 in die spannungsaufnehmende Schicht eingebracht werden. Rechts sind das vertikale und laterale Dotierprofil dargestellt. Die Donator-Konzentration ist im lateralen Dotierprofil nach oben aufgetragen, während die Akzeptor-Konzentration nach unten aufgetragen ist. 45 bezeichnet eine Übergangszone mit Nettodotierung nahe Null.

Viele weitere Halbleiterbauelemente 4 mit vertikaler Struktur können mit dem erfindungsgemäßen Verfahren hergestellt werden.

## Patentansprüche

1. Verfahren zur Herstellung von vertikalen Halbleiterbauelementen (4), das folgende Schritte aufweist:
- Bereitstellen eines Substrats (12) aus Halbleitermaterial mit einer Dicke von 4 µm bis 300 µm, wobei das Bereitstellen des Substrats (12) durch Aufspalten eines stabförmigen Ausgangskristalls (2) aus dem Halbleitermaterial in dünne Scheiben erfolgt; und
- Erzeugen einer dotierten Driftzone (21) des Halbleiterbauelements (4) mittels Ionenimplantation in das Substrat (12) unter Verwendung eines Energiefilters (20), wobei der Energiefilter (20) eine mikrostrukturierte Membran mit einem vordefinierten Strukturprofil zur Einstellung eines durch die Implantation hervorgerufenen Dotierstofftiefenprofils und/oder Defekttiefenprofils im Substrat (12) ist, wobei beim Erzeugen der Driftzone (21) die gesamte Driftzone (21) dotiert wird;
wobei das Erzeugen der Driftzone (21) vollständig ohne epitaktische Abscheidung erfolgt.

2. Verfahren nach Anspruch 1, **dadurch gekennzeichnet, dass** das Halbleitermaterial des Substrats (12) SiC ist und eine Dicke von 4 µm bis 30 µm aufweist.

3. Verfahren nach Anspruch 1 oder 2, **dadurch gekennzeichnet, dass** Halbleitermaterial des Substrats (12) vor dem Erzeugen der Driftzone (21) undotiert oder schwach n-dotiert ist.

4. Verfahren nach einem der vorangehenden Ansprüche, **dadurch gekennzeichnet, dass** die Dicke des Substrats (12) zwischen 4 und 25 µm, bevorzugt zwischen 4 und 20 µm, mehr bevorzugt zwischen 4 und 15 µm, mehr bevorzugt zwischen 6 und 14 µm, mehr bevorzugt zwischen 7 und 13 µm beträgt.

5. Verfahren nach einem der vorangehenden Ansprüche, **dadurch gekennzeichnet, dass** sich die Driftzone (21) über 40 bis 100%, bevorzugt 50 bis 98%, mehr bevorzugt 60 bis 95% der Höhe des Substrats (12) erstreckt.

6. Verfahren nach einem der vorangehenden Ansprüche, **dadurch gekennzeichnet, dass** die Driftzone (21) nach der Ionenimplantation n-dotiert ist.

7. Verfahren nach einem der vorangehenden Ansprüche, **dadurch gekennzeichnet, dass** das Erzeugen der dotierten Driftzone (21) durch Ionenimplantation von einer Seite des Substrats (12) erfolgt.

8. Verfahren nach einem der Ansprüche 1 bis 6, **dadurch gekennzeichnet, dass** das Erzeugen der dotierten Driftzone (21) durch Ionenimplantation von zwei Seiten des Substrats (12) erfolgt.

9. Verfahren nach Anspruch 8, **dadurch gekennzeichnet, dass** das Substrat (12) zwischen den Implantationen um 180° gedreht wird.

10. Verfahren nach Anspruch 9, **dadurch gekennzeichnet, dass** das durch jede der beiden lonenimplantationen von den zwei Seiten des Substrats (12) erzeugte erste und zweite Dotierprofil jeweils von einem ersten Randbereich bzw. einem dem ersten Randbereich gegenüberliegenden zweiten Randbereich des Substrats (12) zu einem Mittelbereich des Substrats (12) hin ein Konzentrationsplateau (P1, P2) und in einem Mittelbereich des Substrats (12) eine abfallende Dotierflanke (S1, S2) aufweist.

11. Verfahren nach Anspruch 10, **dadurch gekennzeichnet, dass** zumindest eines der Konzentrationsplateaus (P1, P2), bevorzugt das dem zweiten Randbereich zugeordnete Konzentrationsplateau (P2), von dem jeweiligen Randbereich des Substrats (12) hin zum Mittelbereich des Substrats (12) abfällt.

12. Verfahren nach einem der Ansprüche 8 bis 11, **dadurch gekennzeichnet, dass** sich die beiden Dotierflanken (S1, S2) in einem Mittelbereich des Substrats (12) schneiden und sich die beiden Dotierprofile somit in dem Mittelbereich überlagern.

13. Verfahren nach einem der vorangehenden Ansprüche, **dadurch gekennzeichnet, dass** das Erzeugen der dotierten Driftzone (21) mit Ionen aus Stickstoff, Phosphor oder Wasserstoff als Dotierstoff erfolgt.

14. Verfahren nach einem der vorangehenden Ansprüche, **dadurch gekennzeichnet, dass** eine dotierte Feldstoppschicht (18) an einem Rand des Substrats (12) mittels Ionenimplantation unter Verwendung eines Energiefilters (20) erzeugt wird.

15. Verfahren nach einem der vorangehenden Ansprüche, **dadurch gekennzeichnet, dass** eine oberflächliche funktionale Zone (24) mit Bereichen unterschiedlicher Dotierung unter Verwendung von Ionenimplantation mit einem Energiefilter (20) erzeugt wird.

## Claims

1. A method for the production of vertical semiconductor components (4), which comprises the steps of:
- providing a substrate (12) of semiconductor material with a thickness of 4 µm to 300 µm, wherein providing the substrate (12) is carried out by splitting a rod-shaped starting crystal (2) of the semiconductor material into thin plates; and
- producing a doped drift zone (21) of the semiconductor component (4) by means of ion implantation in the substrate (12) using an energy filter (20), wherein the energy filter (20) is a microstructured membrane with a predefined structural profile for setting a dopant depth profile and/or a defect depth profile produced in the substrate (12) by the implantation, wherein, when the drift zone (21) is produced, the entire drift zone (21) is doped;
wherein producing the drift zone (21) is carried out completely without any epitactic deposition.

2. The method of claim 1, **characterized in that** the semiconductor material of the substrate (12) is SiC and **in that** it has a thickness of 4 µm to 30 µm.

3. The method of claim 1 or claim 2, **characterized in that** the semiconductor material of the substrate (12) is undoped or weakly n-doped prior to producing the drift zone (21).

4. The method of one of the preceding claims, **characterized in that** the thickness of the substrate (12) is between 4 and 25 µm, preferably between 4 and 20 µm, more preferably between 4 and 15 µm, more preferably between 6 and 14 µm, more preferably between 7 and 13 µm.

5. The method of one of the preceding claims, **characterized in that** the drift zone (21) extends over 40 to 100%, preferably over 50-98%, more preferably over 60-95% of the height of the substrate (12).

6. The method of one of the preceding claims, **characterized in that** the drift zone (21) is n-doped after the ion implantation.

7. The method of one of the preceding claims, **characterized in that** producing the doped drift zone (21) is carried out by ion implantation from one side of the substrate (12).

8. The method of one of claims 1 to 6, **characterized in that** producing the doped drift zone (21) is carried out by ion implantation from two sides of the substrate (12).

9. The method of claim 8, **characterized in that** the substrate (12) is rotated by 180° between the implantations.

10. The method of claim 9, **characterized in that** the first and second dopant profiles produced by the two ion implantations from the two sides of the substrate (12) each comprises a concentration plateau (P1, P2), wherein one concentration plateau (P1) extends from a first edge area toward a middle area of the substrate (12) and the other concentration plateau (P2) extends from a second edge area of the substrate (12) opposite the first edge area also toward the middle area, and wherein each of the first and second dopant profiles also comprises a falling doping flank (S1, S2) in a middle area of the substrate (12).

11. The method of claim 10, **characterized in that** at least one of the concentration plateaus (P1, P2), preferably the concentration plateau (P2) assigned to the second edge area, falls from the associated edge area of the substrate (12) toward the middle area of the substrate (12).

12. The method of one of claims 8 to 11, **characterized in that** the two doping flanks (S1, S2) intersect in a middle area of the substrate (12), the two dopant profiles thus overlapping in the middle area.

13. The method of one of the preceding claims, **characterized in that** producing the doped drift zone (21) is carried out with ions of nitrogen, phosphorus, or hydrogen as doping substance.

14. The method of one of the preceding claims, **characterized in that** a doped field-stop layer (18) is produced at an edge area of the substrate (12) by means of ion implantation using an energy filter (20).

15. The method of one of the preceding claims, **characterized in that** a superficial functional zone (24) with areas of different dopings is produced by using ion implantation with an energy filter (20).

## Revendications

1. Procédé de fabrication de composants verticaux de semiconducteurs (4), qui comprend les étapes suivantes :
- mise à disposition d'un substrat (12) en matériau semi-conducteur ayant une épaisseur de 4 µm à 300 µm, la mise à disposition du substrat (12) s'effectuant par séparation d'un cristal de départ en forme de bâtonnet (2) composé du matériau semi-conducteur en tranches minces ; et
- création d'une zone de dérive dopée (21) du composant de semi-conducteur (4) au moyen d'une implantation d'ions dans le substrat (12) en utilisant un filtre d'énergie (20), le filtre d'énergie (20) étant une membrane microstructurée ayant un profil structurel prédéfini pour le réglage d'un profil de profondeur de dopant et/ou d'un profil de profondeur de défaut suscité par l'implantation dans le substrat (12), la totalité de la zone de dérive (21) étant dopée lors de la création de la zone de dérive (21) ;
dans lequel la création de la zone de dérive (21) s'effectue totalement sans dépôt épitaxial.

2. Procédé selon la revendication 1, **caractérisé en ce que** le matériau semi-conducteur du substrat (12) est le SiC et présente une épaisseur de 4 µm à 30 µm.

3. Procédé selon la revendication 1 ou 2, **caractérisé en ce que** le matériau semi-conducteur du substrat (12) n'est pas dopé avant la création de la zone de dérive (21) ou est faiblement dopé n.

4. Procédé selon l'une des revendications précédentes, **caractérisé en ce que** l'épaisseur du substrat (12) est comprise entre 4 et 25 µm, de préférence entre 4 et 20 µm, de manière mieux préférée entre 4 et 15 µm, de manière mieux préférée entre 6 et 14 µm, de manière mieux préférée entre 7 et 13 µm.

5. Procédé selon l'une des revendications précédentes, **caractérisé en ce que** la zone de dérive (21) s'étend sur 40 à 100 %, de préférence 50 à 98 %, de manière mieux préférée 60 à 95 % de la hauteur du substrat (12).

6. Procédé selon l'une des revendications précédentes, **caractérisé en ce que** la zone de dérive (21) est dopée n après l'implantation d'ions.

7. Procédé selon l'une des revendications précédentes, **caractérisé en ce que** la création de la zone de dérive dopée (21) s'effectue par l'implantation d'ions d'une face du substrat (12).

8. Procédé selon l'une des revendications 1 à 6, **caractérisé en ce que** la création de la zone de dérive dopée (21) s'effectue par l'implantation d'ions de deux faces du substrat (12).

9. Procédé selon la revendication 8, **caractérisé en ce que** le substrat (12) est tourné de 180° entre les implantations.

10. Procédé selon la revendication 9, **caractérisé en ce que** le premier et le deuxième profils de dopage créés par chacune des deux implantations d'ions des deux faces du substrat (12) présentent respectivement depuis une première région périphérique et/ou une deuxième région périphérique du substrat (12) opposée à la première région périphérique allant jusqu'à une région médiane du substrat (12) un plateau de concentration (P1, P2) et, dans une zone médiane du substrat (12), un flanc de dopage décroissant (S1, S2).

11. Procédé selon la revendication 10, **caractérisé en ce qu'**au moins l'un des plateaux de concentration (P1, P2), de préférence le plateau de concentration (P2) associé à la deuxième région périphérique, décroît depuis la région périphérique respective du substrat (12) jusqu'à la région médiane du substrat (12).

12. Procédé selon l'une des revendications 8 à 11, **caractérisé en ce que** les deux flancs de dopage (S1, S2) se coupent dans une zone médiane du substrat (12) et les deux profils de dopage se chevauchent donc dans la zone médiane.

13. Procédé selon l'une des revendications précédentes, **caractérisé en ce que** la création de la zone de dérive dopée (21) s'effectue avec des ions azote, phosphore ou hydrogène comme dopant.

14. Procédé selon l'une des revendications précédentes, **caractérisé en ce qu'**une couche dopée de blocage de champ (18) est créée sur un bord du substrat (12) au moyen d'une implantation d'ions en utilisant un filtre d'énergie (20).

15. Procédé selon l'une des revendications précédentes, **caractérisé en ce qu'**une zone fonctionnelle superficielle (24) est créée avec des régions de dopage différent en utilisant l'implantation d'ions avec un filtre d'énergie (20).
